# EUROPEAN PATENT SPECIFICATION

(11) **EP 3 399 565 B1**
(45) Date of publication and mention of the grant of the patent: **29.07.2020**
(21) Application number: 16881569.4
(22) Date of filing: 24.11.2016
(51) Int. Cl.: H01L 51/50, C09K 11/06

(54) **ORGANIC ELECTROLUMINESCENCE ELEMENT**
ORGANISCHES ELEKTROLUMINESZENZELEMENT
ÉLÉMENT ÉLECTROLUMINESCENT ORGANIQUE

(30) Priority: 28.12.2015 JP 2015257096
(43) Date of publication of application: 07.11.2018
(73) Proprietor: NIPPON STEEL Chemical & Material Co., Ltd., Tokyo 103-0027 (JP)
(72) Inventor: TADA, Masashi, Kitakyushu-shi Fukuoka 804-8503 (JP); SAWADA, Yuichi, Kitakyushu-shi Fukuoka 804-8503 (JP); UEDA, Tokiko, Kitakyushu-shi Fukuoka 804-8503 (JP)
(74) Representative: Vossius & Partner Patentanwälte Rechtsanwälte mbB
(86) International application number: PCT/JP2016/084751
(87) International publication number: WO 2017/115589

(56) References cited:
- EP-A1- 3 010 065
- WO-A1-2012/035934
- JP-A- 2010 205 815
- JP-A- 2015 097 201
- JP-A- 2015 111 624
- JP-A- 2015 119 054
- KR-A- 20100 131 745
- US-A1- 2012 273 764
- US-A1- 2015 001 488
- US-A1- 2015 364 696

## Description

### [Technical Field]

The present invention relates to an organic electroluminescence element (referred to as organic EL element).

### [Background Art]

By applying voltage to an organic EL element, holes and electrons are injected into a light emitting layer from an anode and a cathode, respectively. In the light emitting layer, injected holes and electrons recombine to generate excitons. Upon recombination, according to the electron spin-statistics theorem, singlet excitons and triplet excitons are generated at a ratio of 1:3. It is said that a fluorescent type organic EL element that utilizes luminescence from singlet excitons has a limit of the internal quantum efficiency of 25%. Meanwhile, it is known that when intersystem crossing is efficiently carried out from singlet excitons in a phosphorescent type organic EL element that utilizes luminescence from triplet excitons, the internal quantum efficiency may be increased to 100%.

However, phosphorescent type organic EL elements have a technical issue of extension of lifetime.

Further, highly efficient organic EL elements that utilize delayed fluorescence have been developed recently. For example, PTL 1 discloses an organic EL element that utilizes one of the delayed fluorescence mechanisms, TTF (Triplet-Triplet Fusion) mechanism. The TTF mechanisms utilize the phenomenon of collision of two triplet excitons which then generate a singlet exciton. It is believed that theoretically the internal quantum efficiency may be increased up to 40%. However, the efficiency is lower than phosphorescent organic EL elements, and thus a further improvement of efficiency is sought.

Meanwhile, PTL 2 discloses an organic EL element exploiting TADF (Thermally Activated Delayed Fluorescence) mechanism. The TADF mechanism is to utilize the phenomenon of reverse intersystem crossing from triplet excitons to singlet excitons in a material having a small energy difference between the singlet level and the triplet level. It is believed that theoretically the internal quantum efficiency may be increased up to 100%. However, similar to phosphorescent type elements, a further improvement of lifetime is sought.

### [Citation List]

### [Patent Literature]

[PTL 1] WO 2010/134350 A1
[PTL 2] WO 2011/070963 A1
[PTL 3] Japanese Patent Application Publication No. 2010-205815 [PTL 4] WO 2011/055933 A1
[PTL 5] US 2015/0001488 A1
[PTL 6] WO 2012/035934 A1

PTL 3 discloses a material for an organic EL element containing a compound having a partial structure represented by the following general formula: 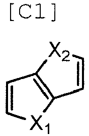 wherein X₁ and X₂ respectively represent different chalcogen atoms.

PTL 4 discloses use of an indoloindole compound as a host mixture.

PTL 6 discloses use of an indoloindole compound as a host material.

PTL 5 discloses use of a biscarbazole compound and an indolocarbazole compound indicated below as a host mixture.

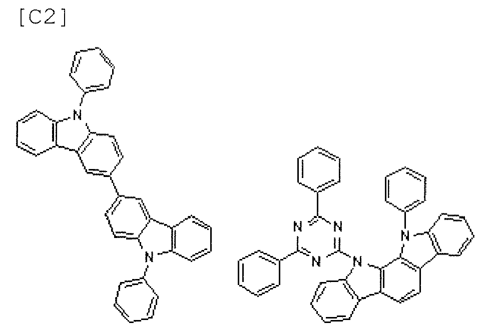

US2015364696 A1 discloses an OLED comprising an organic layer between a first and a second electrode the organic layer comprising an emission layer, wherein the emission layer comprises a host represented by Formula 1 (corresponding to formula 2 of claim 1 of the present application) and a further host represented by Formula 2.

However, neither of the above is satisfactory and a further improvement is desired.

### [Summary of Invention]

In order to apply an organic EL element to display elements such as flat panel displays or light sources, it is required to improve the luminescent efficiency of the element and at the same time sufficiently secure the stability during driving. With the foregoing in view, an object of the present invention is to provide a practically useful organic EL element having high efficiency and high driving stability even with low driving voltage.

The present invention is an organic EL element including one or more light emitting layers between an anode and a cathode opposing each other, wherein at least one light emitting layer contains a first host selected from compounds represented by the following general formula (1), a second host selected from compounds represented by the following general formula (2) and a luminescence dopant material: 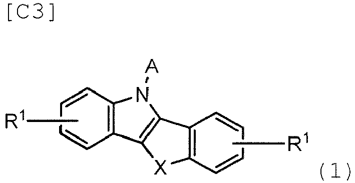 wherein X represents N-A, oxygen or sulphur; A is respectively and independently represent an aromatic hydrocarbon group having 6 to 30 carbon atoms or an aromatic heterocyclic group having 3 to 30 carbon atoms; R¹ is respectively and independently represent hydrogen, an alkyl group having 1 to 10 carbon atoms, an aromatic hydrocarbon group having 6 to 10 carbon atoms or an aromatic heterocyclic group having 3 to 12 carbon atoms; 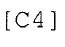 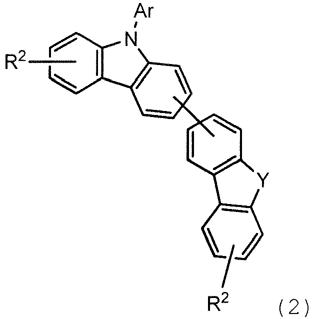 wherein Y represents N-Ar, oxygen or sulphur; Ar represents an aromatic hydrocarbon group having 6 to 30 carbon atoms or an aromatic heterocyclic group having 3 to 30 carbon atoms; R²'s respectively and independently represent hydrogen, an alkyl group having 1 to 10 carbon atoms, an aromatic hydrocarbon group having 6 to 10 carbon atoms or an aromatic heterocyclic group having 3 to 12 carbon atoms.

When Y in general formula (2) represents N-Ar, X in general formula (1) does not represent N-A.

A preferable embodiment of general formula (2) is represented by general formula (3):

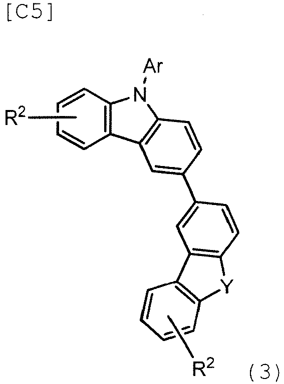

In general formula (3), Y, Ar and R² have the same meanings as Y, Ar and R² in general formula (2). Y is more preferably N-Ar.

A preferred embodiment of general formula (1) includes general formula (4): 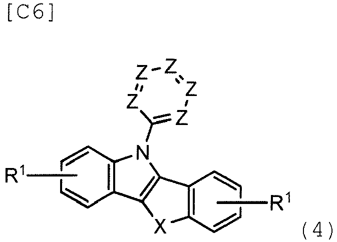 wherein Z is respectively and independently represent N or CR³ and at least one Z is N; and R³ is respectively and independently represent hydrogen, an aromatic hydrocarbon group having 6 to 12 carbon atoms or an aromatic heterocyclic group having 3 to 12 carbon atoms.

In general formula (4), X and R¹ have the same meanings as in general formula (1). X is more preferably either oxygen or sulphur.

It is preferable that the first host and the second host are preliminarily mixed before deposition and used. It is also preferable that the proportion of the first host relative to the sum of the first host and the second host is more than 20 wt% and less than 55 wt%.

The luminescence dopant material may be a phosphorescence dopant material, a fluorescence dopant material or a thermally activated delayed fluorescence dopant material. Examples of the phosphorescence dopant material include an organic metal complex containing at least one metal selected from the group consisting of ruthenium, rhodium, palladium, silver, rhenium, osmium, iridium, platinum and gold.

The organic EL element of the present invention contains a plurality of specific host materials in the light emitting layer, and thus may be an organic EL element having high luminescent efficiency and long lifetime with low driving voltage.

### [Brief Description of Drawing]

[Fig. 1]

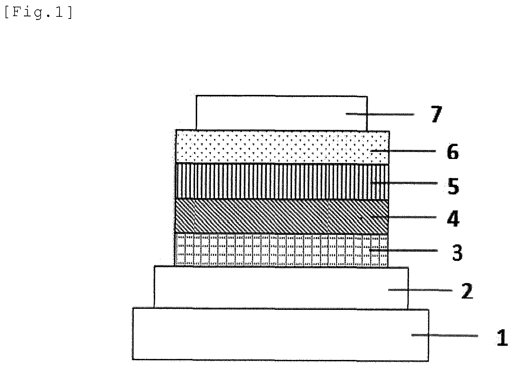

Fig. 1 is a schematic section view illustrating an example of the organic EL element.

### [Description of Embodiment]

The organic EL element of the present invention includes one or more light emitting layers between an anode and a cathode opposing each other, wherein at least one layer of the light emitting layers contains a first host, a second host and a luminescence dopant material. The first host is the compound represented by general formula (1), and the second host is the compound represented by general formula (2). The organic EL element has an organic layer formed from a plurality of layers between an anode and a cathode opposing each other, and at least one of the plurality of layers is a light emitting layer and the light emitting layer may be provided in plurality.

General formulae (1) and (4) are now described. In general formulae (1) and (4), common symbols have the same meanings.

X represents N-A, oxygen or sulphur, preferably oxygen or sulphur and more preferably sulphur.

A is independently represent an aromatic hydrocarbon group having 6 to 30 carbon atoms or an aromatic heterocyclic group having 3 to 30 carbon atoms, preferably an aromatic heterocyclic group having 3 to 30 carbon atoms, more preferably an aromatic heterocyclic group having 3 to 25 carbon atoms. The aromatic hydrocarbon group or the aromatic heterocyclic group may have a substituent, and when the group has a substituent, the substituent is preferably an aromatic hydrocarbon group having 6 to 12 carbon atoms or an aromatic heterocyclic group having 3 to 12 carbon atoms. The number of carbon atoms includes the number of carbon atoms of the substituent.

Specific examples of the aromatic hydrocarbon group having 6 to 30 carbon atoms or the aromatic heterocyclic group having 3 to 30 carbon atoms include aromatic groups generated from benzene, naphthalene, pyridine, pyrimidine, triazine, thiophene, isothiazole, thiazole, pyridazine, pyrrole, pyrazole, imidazole, triazole, thiadiazole, pyrazine, furan, isoxazole, oxazole, oxadiazole, quinoline, isoquinoline, quinoxaline, quinazoline, oxadiazole, thiadiazole, benzotriazine, phthalazine, tetrazole, indole, benzofuran, benzothiophene, benzoxazole, benzothiazole, indazole, benzimidazole, benzotriazole, benzisothiazole, benzothiadiazole, dibenzofuran, dibenzothiophene, dibenzoselenophene, carbazole and linked aromatic compounds in which 2 to 5 foregoing aromatic rings are linked through single bond(s). Preferably, aromatic groups generated by depriving one H from benzene, pyridine, pyrimidine, triazine, quinoline, isoquinoline, quinoxaline, quinazoline and aromatic compounds in which 2 to 5 foregoing rings are linked may be mentioned. More preferably, aromatic groups generated from benzene, pyridine, pyrimidine, triazine and linked aromatic compounds in which 2 to 5 foregoing rings are linked may be mentioned. The linked aromatic compound may be linear such as Ar¹-Ar²-Ar³-Ar⁴-Ar⁵ or branched such as Ar¹-Ar²(Ar³)-Ar⁵, wherein Ar¹ to Ar⁵ may be the same or different and Ar³ to Ar⁵ may be omitted. A bond of the aromatic group generated from the linked aromatic compound may be from the terminal Ar¹ or Ar⁵, or from any of Ar² to Ar⁴ in the middle.

R¹ is independently represent hydrogen, an alkyl group having 1 to 10 carbon atoms, an aromatic hydrocarbon group having 6 to 10 carbon atoms or an aromatic heterocyclic group having 3 to 12 carbon atoms, preferably an aromatic hydrocarbon group having 6 to 8 carbon atoms or an aromatic heterocyclic group having 3 to 10 carbon atoms and more preferably, a phenyl group or an aromatic heterocyclic group having 3 to 6 carbon atoms.

Specific examples of the alkyl group having 1 to 10 carbon atoms include methyl, ethyl, propyl, butyl, pentyl, hexyl, heptyl, octyl, nonyl, decyl and the like.

Specific examples of the aromatic hydrocarbon group having 6 to 10 carbon atoms and the aromatic heterocyclic group having 3 to 12 carbon atoms include aromatic groups generated by depriving one H from benzene, naphthalene, pyridine, pyrimidine, triazine, thiophene, isothiazole, thiazole, pyridazine, pyrrole, pyrazole, imidazole, triazole, thiadiazole, pyrazine, furan, isoxazole, oxazole, oxadiazole, quinoline, isoquinoline, quinoxaline, quinazoline, oxadiazole, thiadiazole, benzotriazine, phthalazine, tetrazole, indole, benzofuran, benzothiophene, benzoxazole, benzothiazole, indazole, benzimidazole, benzotriazole, benzisothiazole, benzothiadiazole, dibenzofuran, dibenzothiophene, dibenzoselenophene and carbazole. Preferably, aromatic groups generated from benzene, pyridine, pyrimidine, triazine, thiophene, isothiazole, thiazole, pyridazine, pyrrole, pyrazole, imidazole, triazole, thiadiazole, pyrazine, furan, isoxazole, oxazole, oxadiazole, quinoline, isoquinoline, quinoxaline, quinazoline, oxadiazole, thiadiazole, benzotriazine, phthalazine, tetrazole, indole, benzofuran, benzothiophene, benzoxazole, benzothiazole, indazole, benzimidazole, benzotriazole, benzisothiazole and benzothiadiazole may be mentioned. More preferably, aromatic groups generated from benzene, pyridine, pyrimidine, triazine, thiophene, isothiazole, thiazole, pyridazine, pyrrole, pyrazole, imidazole, triazole, thiadiazole, pyrazine, furan, isoxazole, oxazole and oxadiazole may be mentioned.

Z's independently represent N or CR³ and at least one Z is N. R³'s respectively and independently represent hydrogen, an aromatic hydrocarbon group having 6 to 12 carbon atoms or an aromatic heterocyclic group having 3 to 12 carbon atoms.

Specific examples of R³ which is an aromatic hydrocarbon group having 6 to 12 carbon atoms or an aromatic heterocyclic group having 3 to 12 carbon atoms include aromatic groups generated from benzene, naphthalene, pyridine, pyrimidine, triazine, thiophene, isothiazole, thiazole, pyridazine, pyrrole, pyrazole, imidazole, triazole, thiadiazole, pyrazine, furan, isoxazole, oxazole, oxadiazole, quinoline, isoquinoline, quinoxaline, quinazoline, oxadiazole, thiadiazole, benzotriazine, phthalazine, tetrazole, indole, benzofuran, benzothiophene, benzoxazole, benzothiazole, indazole, benzimidazole, benzotriazole, benzisothiazole, benzothiadiazole, dibenzofuran, dibenzothiophene, dibenzoselenophene, carbazole and linked aromatic compounds in which 2 foregoing rings groups are linked. Preferably, aromatic groups generated by depriving one H from benzene, pyridine, pyrimidine, triazine, quinoline, quinazoline, dibenzothiophene, dibenzofuran and linked aromatic compounds in which 2 foregoing groups are linked may be mentioned. More preferably, aromatic groups generated from benzene and biphenyl may be mentioned.

Specific examples of the compound represented by general formula (1) are shown below. However, the compound is not limited to those exemplified compounds.

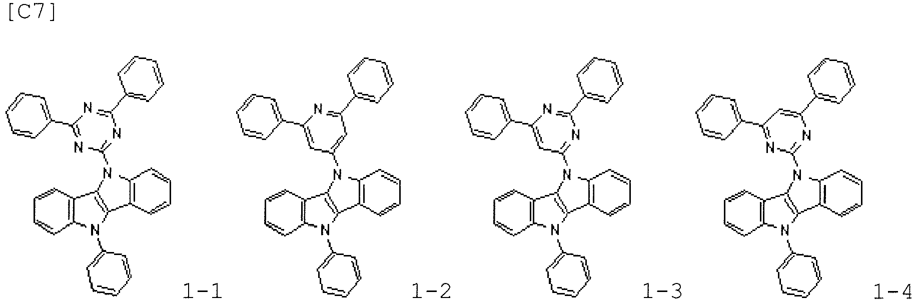

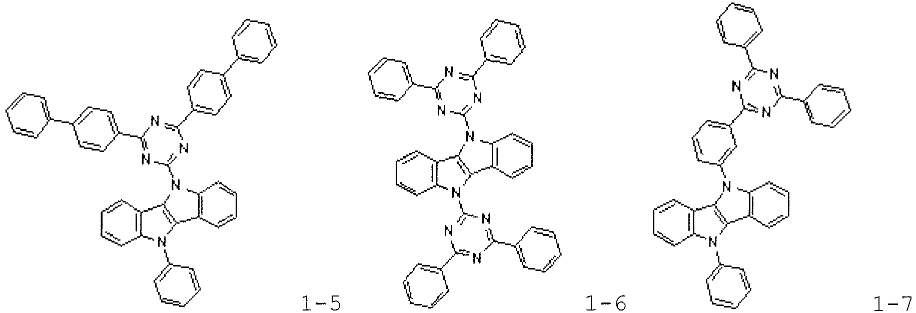

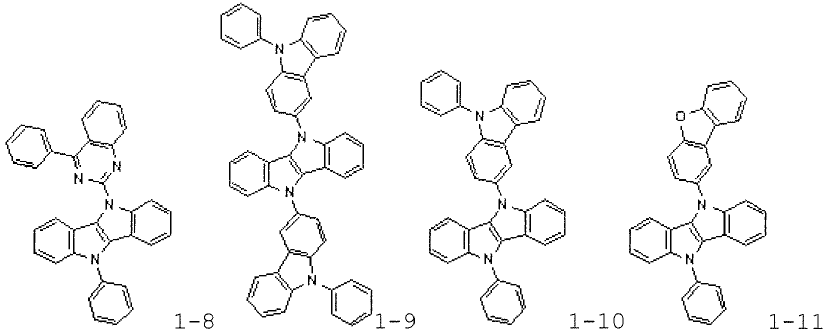

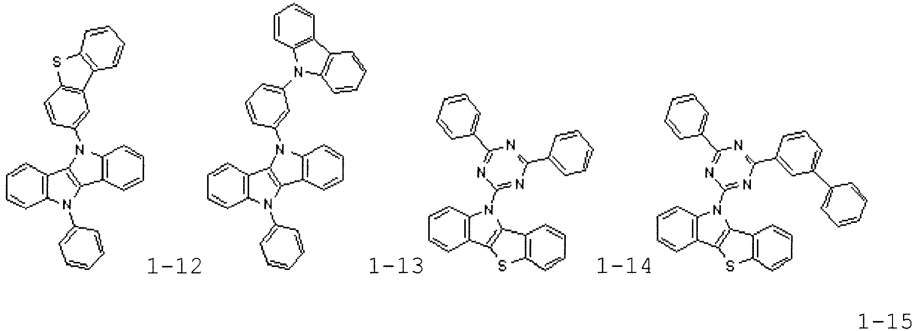

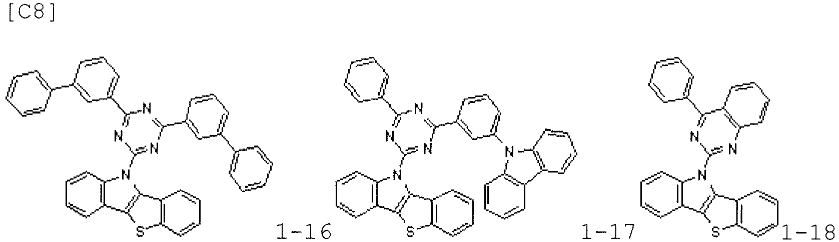

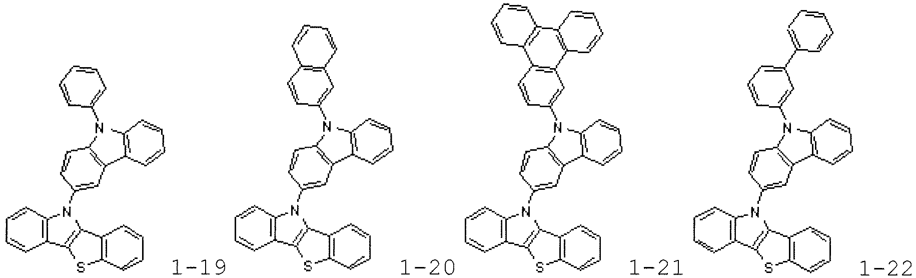

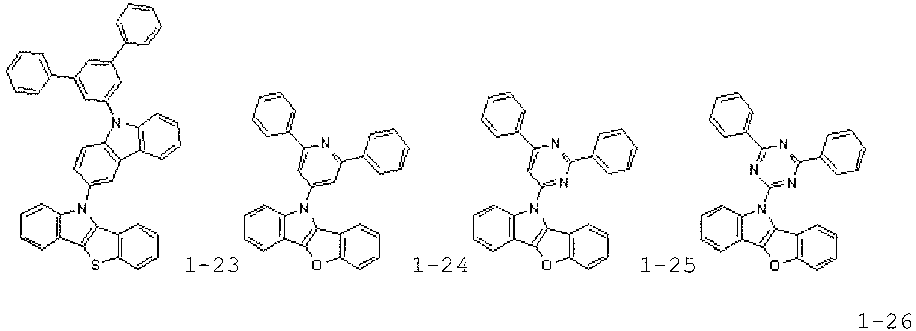

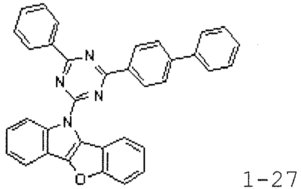

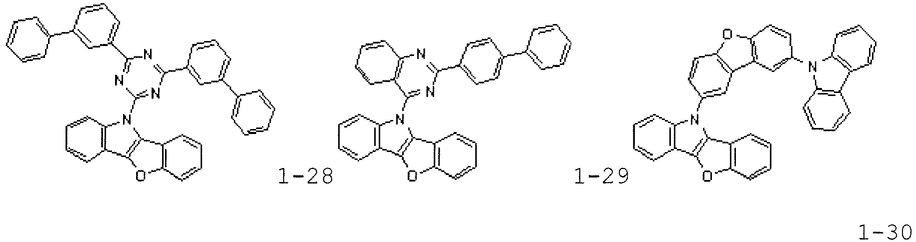

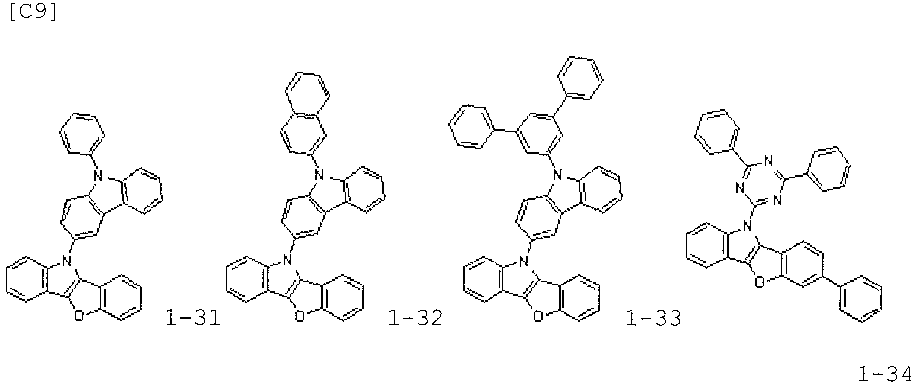

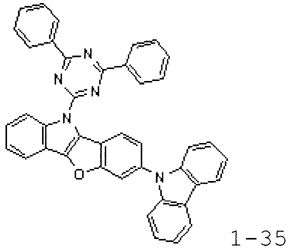

The compound of general formula (2) or general formula (3) which serves as the second host is now described. In general formulae (2) and (3), common symbols have the same meanings.

Y represents N-Ar, oxygen or sulphur, preferably oxygen or sulphur and more preferably sulphur.

Ar represents an aromatic hydrocarbon group having 6 to 30 carbon atoms or an aromatic heterocyclic group having 3 to 30 carbon atoms, preferably an aromatic hydrocarbon group having 6 to 18 carbon atoms or an aromatic heterocyclic group having 3 to 17 carbon atoms and more preferably, an aromatic hydrocarbon group having 6 to 18 carbon atoms.

Specific examples of the aromatic hydrocarbon group having 6 to 30 carbon atoms or the aromatic heterocyclic group having 3 to 30 carbon atoms include aromatic groups generated from benzene, naphthalene, anthracene, phenanthrene, pyrene, triphenylene, pyridine, pyrimidine, triazine, thiophene, isothiazole, thiazole, pyridazine, pyrrole, pyrazole, imidazole, triazole, thiadiazole, pyrazine, furan, isoxazole, oxazole, oxadiazole, quinoline, isoquinoline, quinoxaline, quinazoline, oxadiazole, thiadiazole, benzotriazine, phthalazine, tetrazole, indole, benzofuran, benzothiophene, benzoxazole, benzothiazole, indazole, benzimidazole, benzotriazole, benzisothiazole, benzothiadiazole, dibenzofuran, dibenzothiophene, dibenzoselenophene, carbazole and linked aromatic compounds in which 2 to 5 foregoing groups are linked. Preferably, aromatic groups generated by depriving one H from benzene, naphthalene, anthracene, phenanthrene, pyrene, triphenylene, pyridine, pyrimidine, triazine, quinoline, isoquinoline, quinoxaline, quinazoline and linked aromatic compounds in which 2 to 5 foregoing groups are linked may be mentioned. More preferably, aromatic groups generated from benzene, naphthalene, anthracene, triphenylene and linked aromatic groups in which 2 to 5 foregoing groups are linked may be mentioned.

R²'s independently represent hydrogen, an alkyl group having 1 to 10 carbon atoms, an aromatic hydrocarbon group having 6 to 10 carbon atoms or an aromatic heterocyclic group having 3 to 12 carbon atoms, preferably an aromatic hydrocarbon group having 6 to 8 carbon atoms or an aromatic heterocyclic group having 3 to 10 carbon atoms and more preferably a phenyl group or an aromatic heterocyclic group having 3 to 6 carbon atoms. The details for the alkyl group, the aromatic hydrocarbon group and the aromatic heterocyclic group are the same as those for R¹ above.

Specific examples of the compound represented by general formulae (2) and (3) are shown below. However, the compound is not limited to those exemplified compounds.

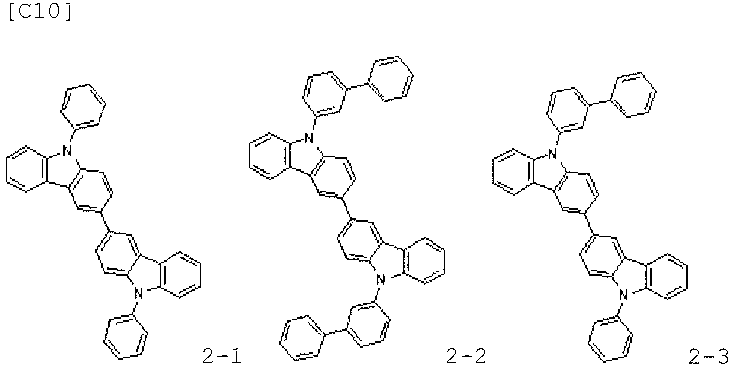

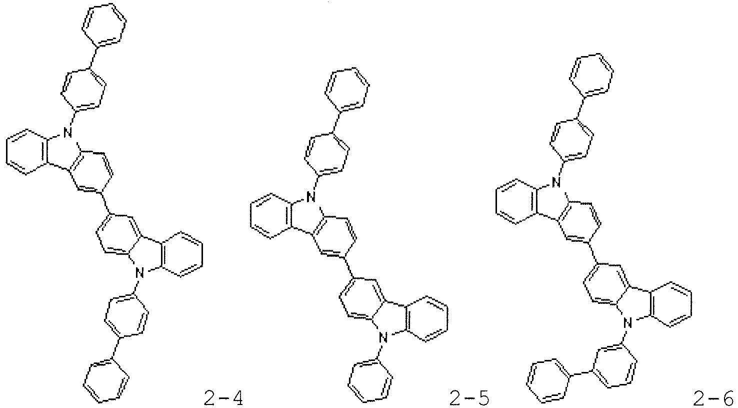

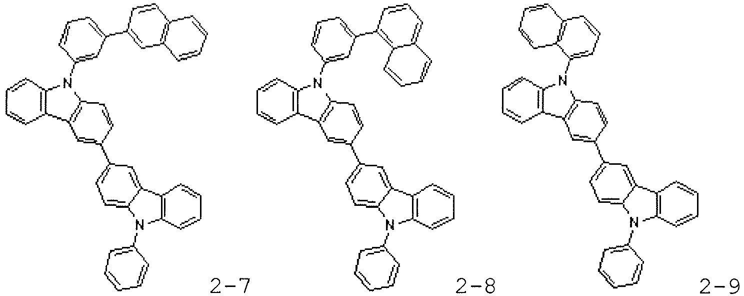

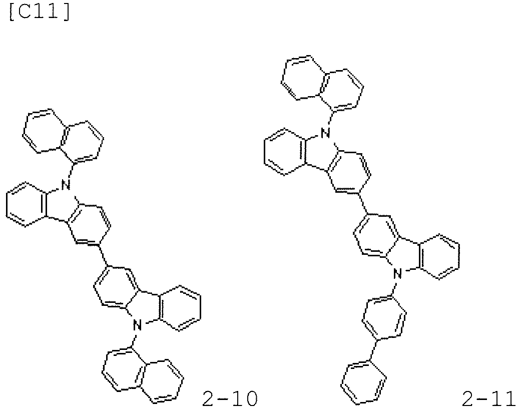

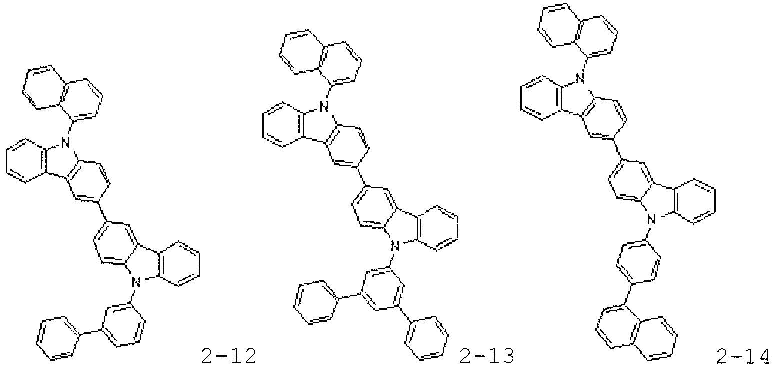

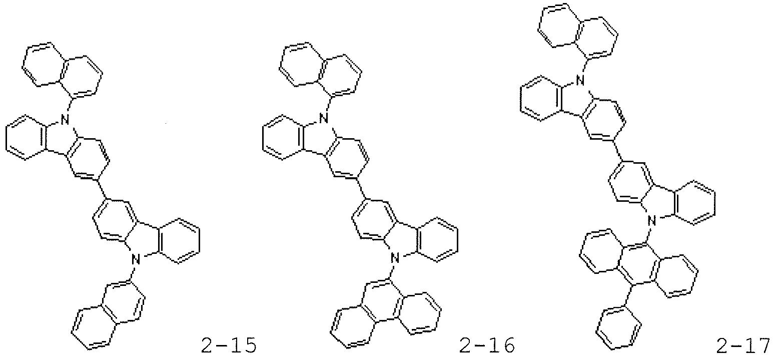

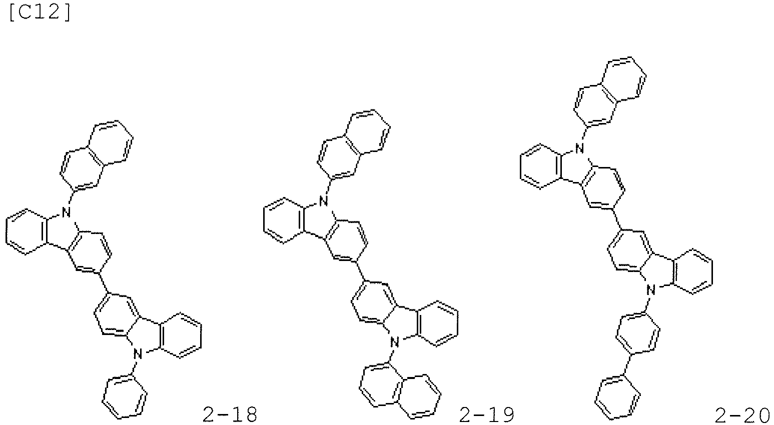

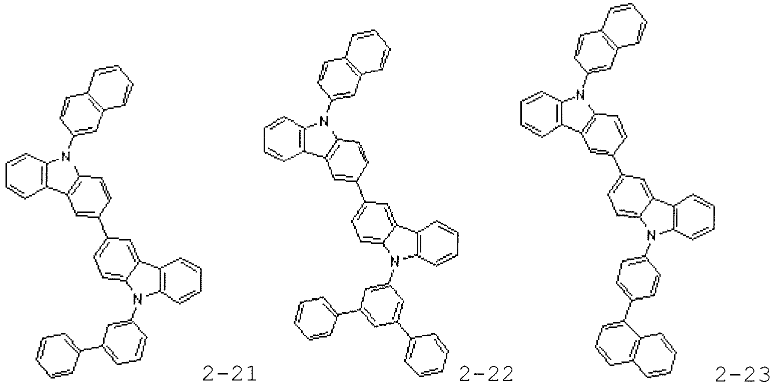

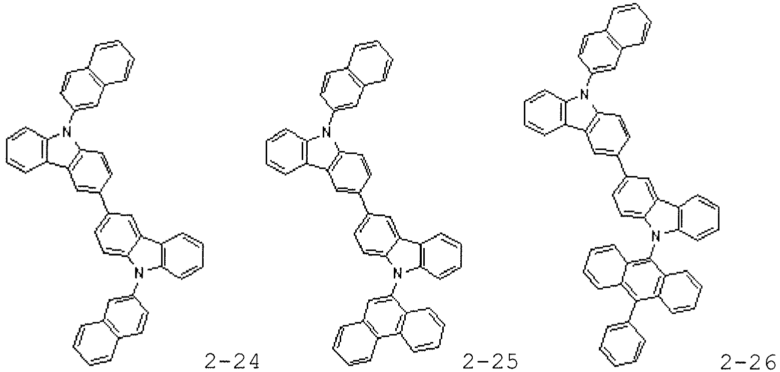

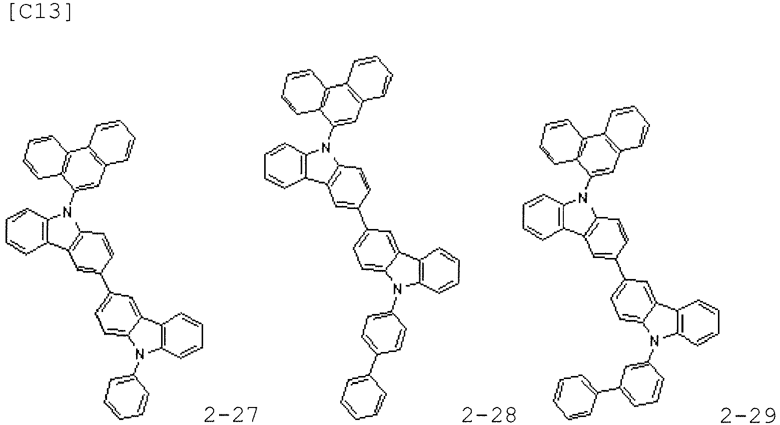

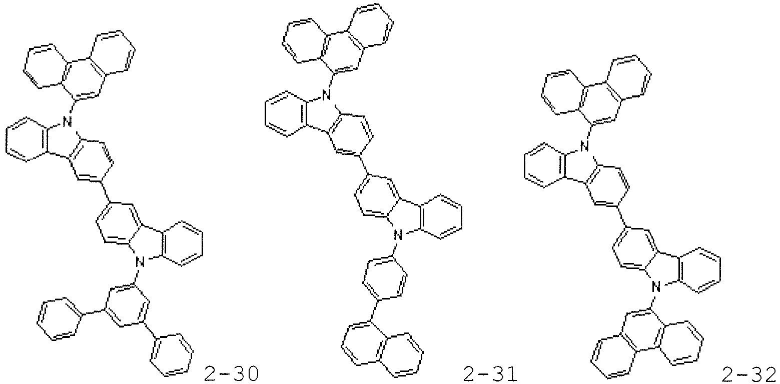

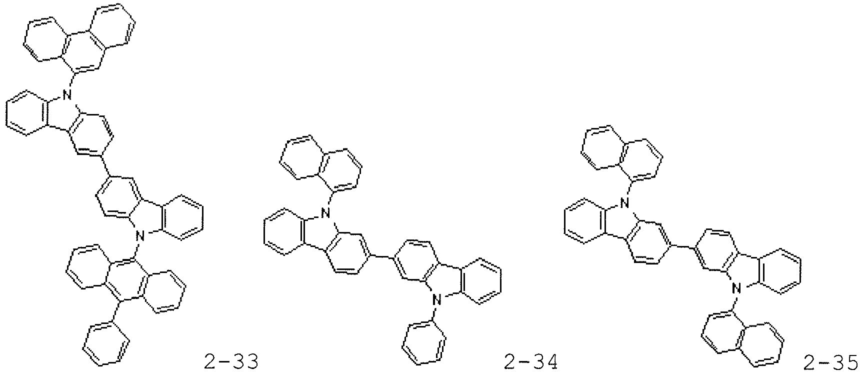

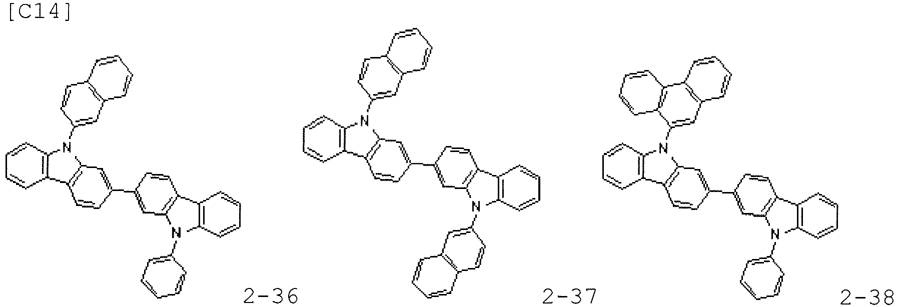

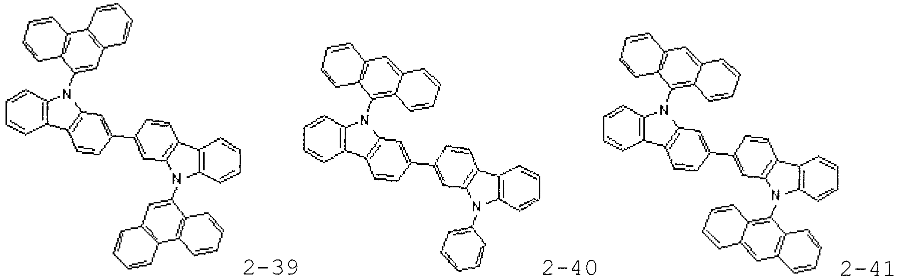

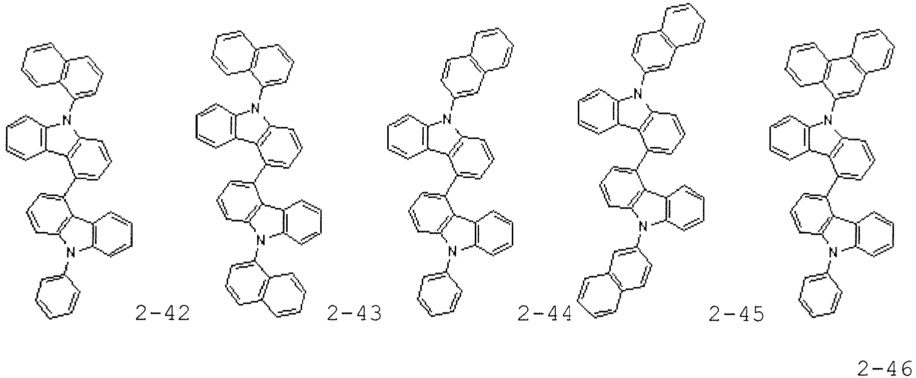

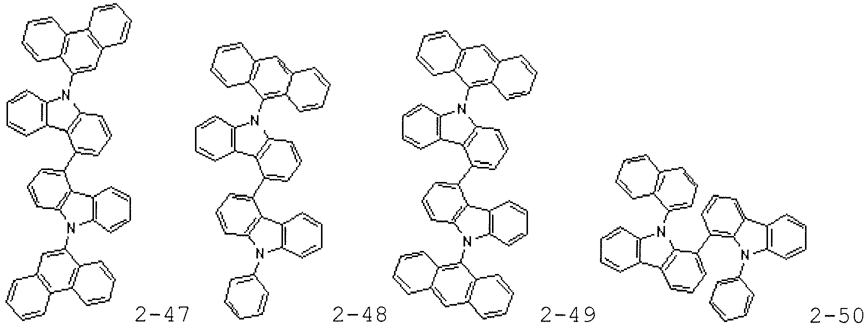

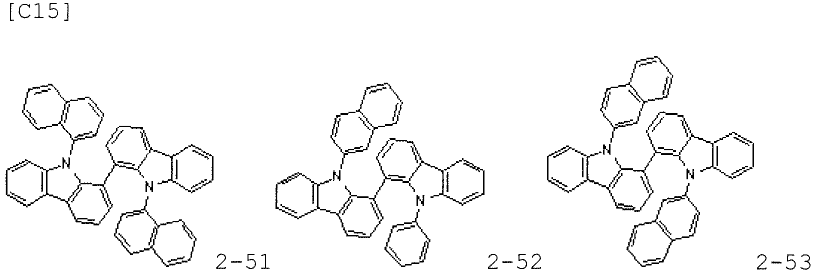

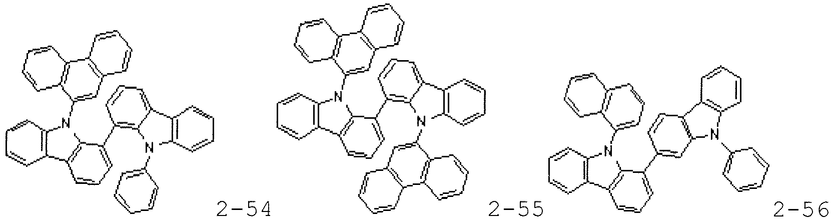

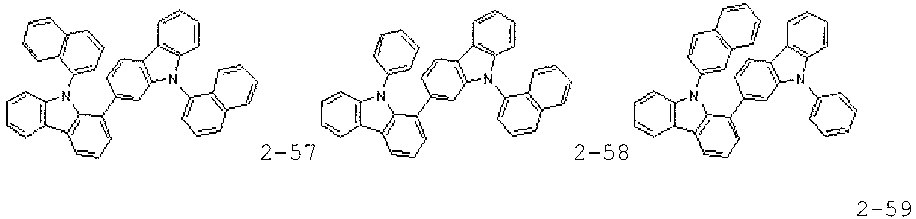

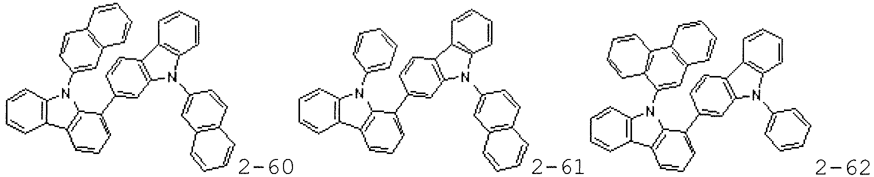

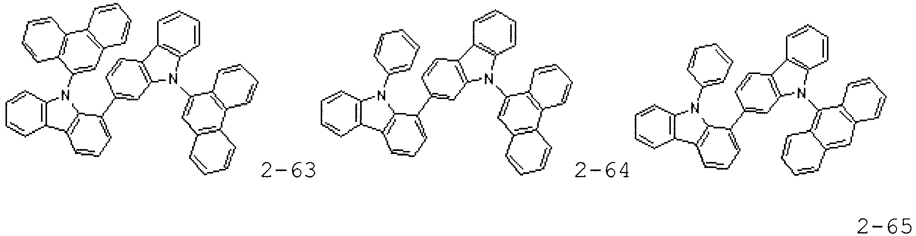

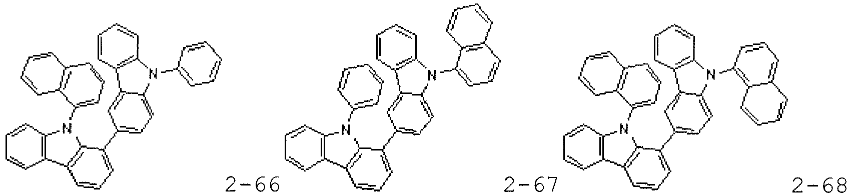

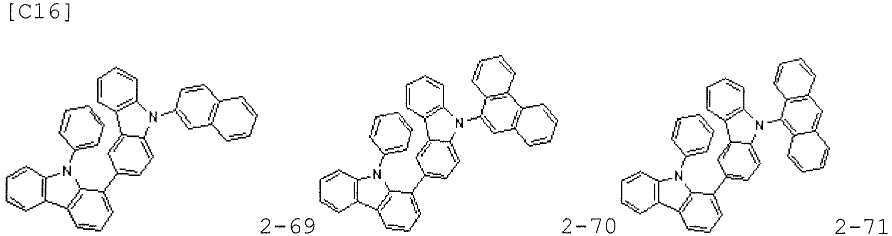

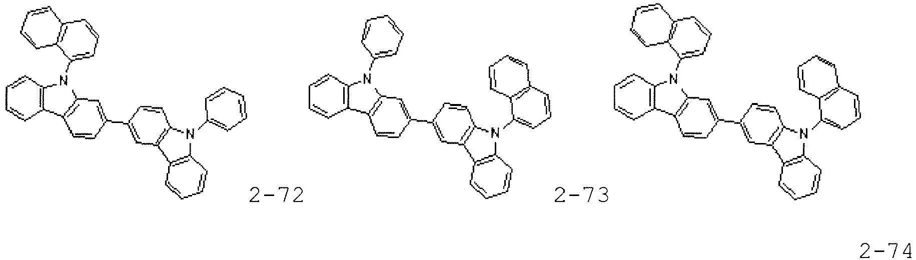

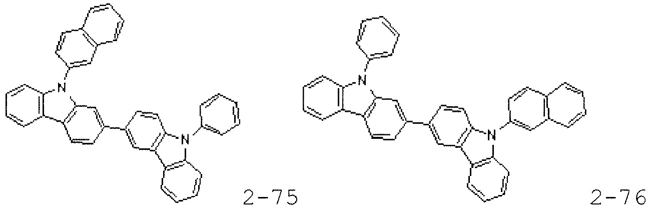

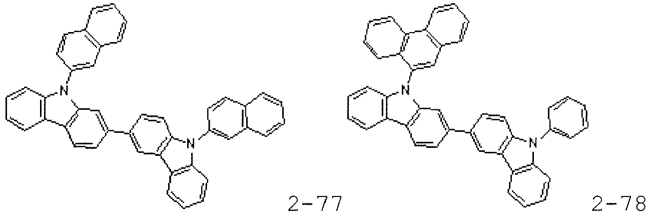

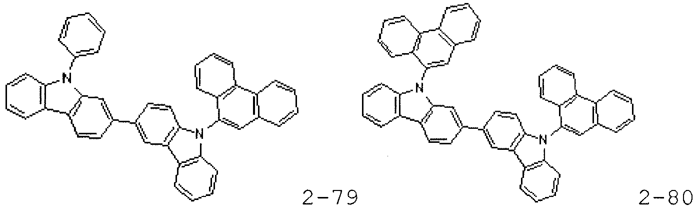

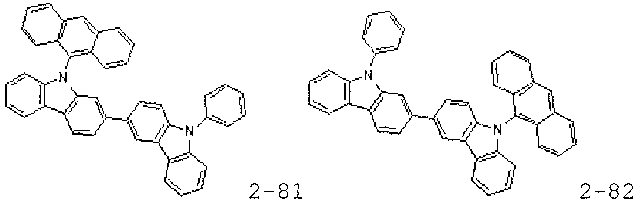

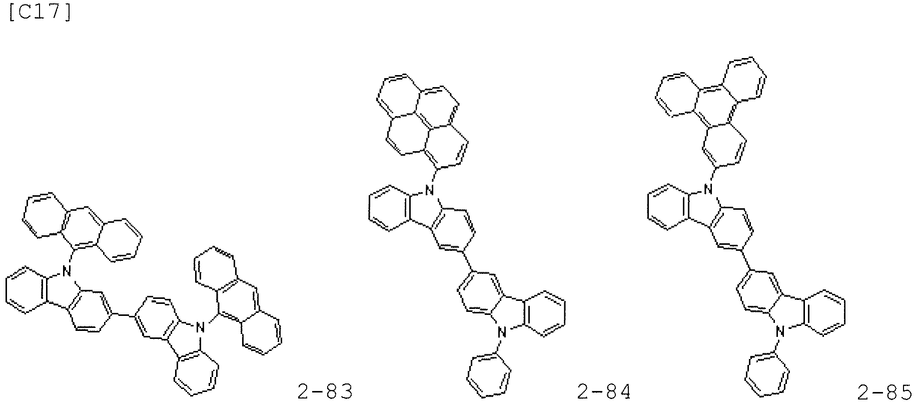

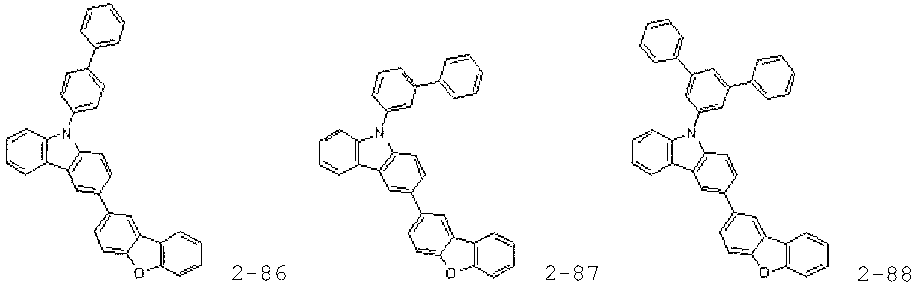

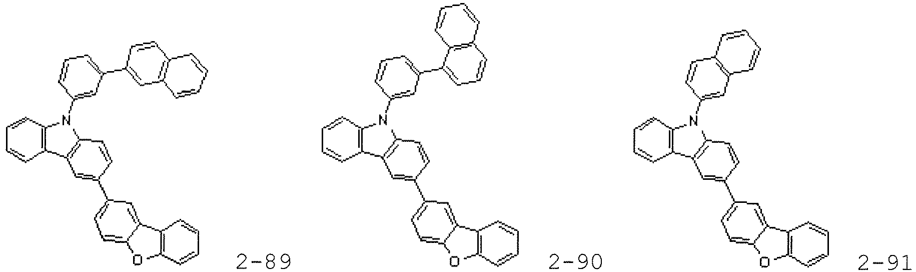

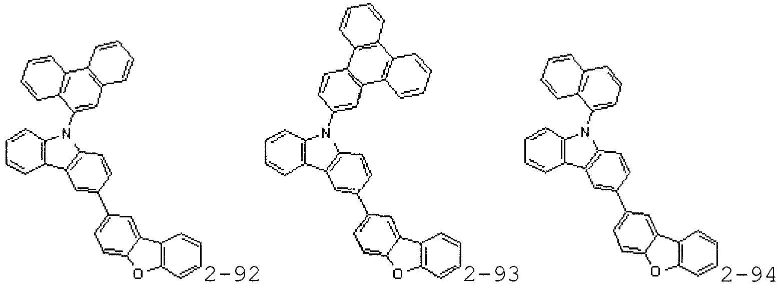

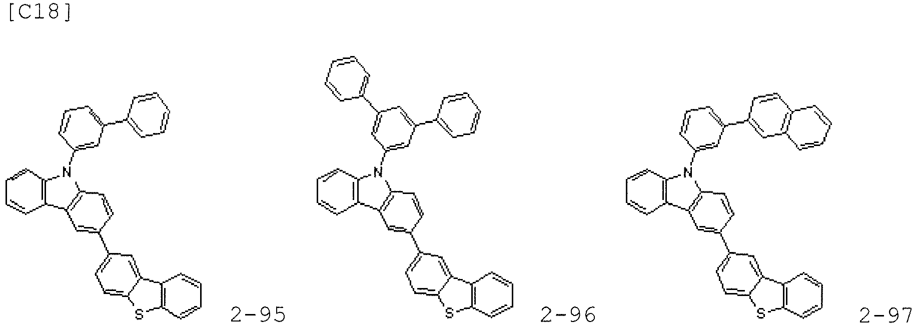

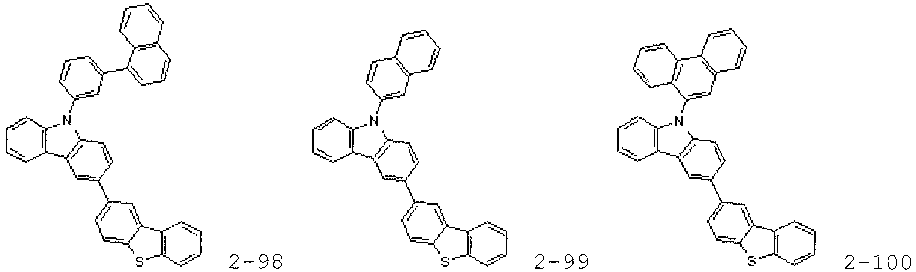

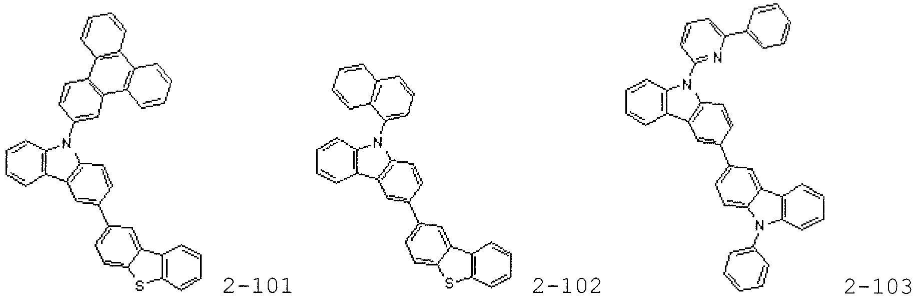

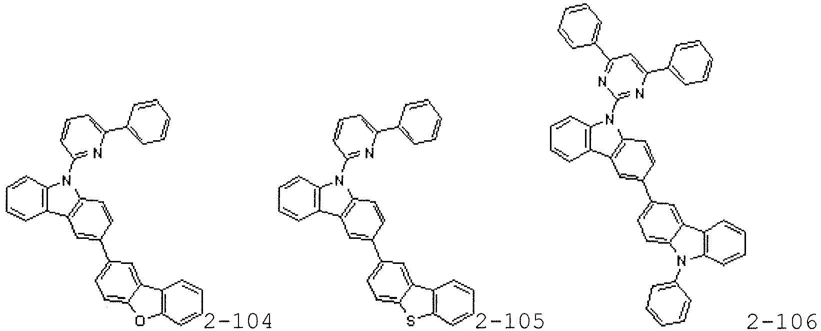

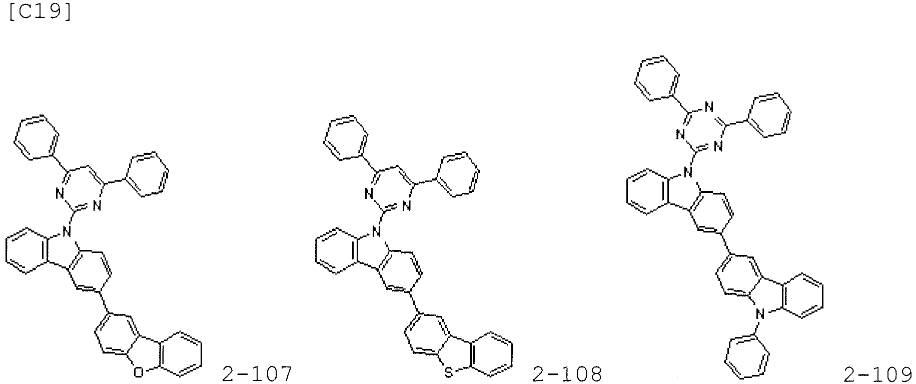

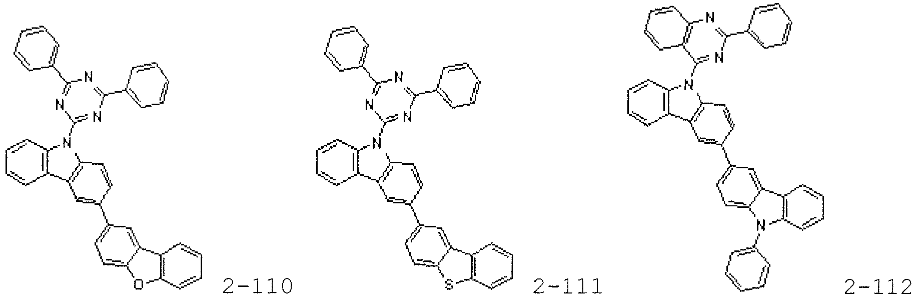

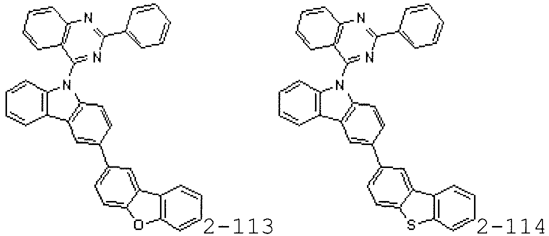

By using the first host selected from compounds represented by general formula (1) and the second host selected from compounds represented by general formula (2) as host materials of the light emitting layer, an excellent organic EL element may be provided.

The first host and the second host may be deposited from respective sources of deposition; however, it is preferable that the first host and the second host are preliminarily mixed before deposition to obtain a preliminary mixture which is deposited from one source of deposition to form the light emitting layer. In this case, the preliminary mixture may contain a luminescence dopant material that is required for formation of the light emitting layer or another host that may be used if necessary. However, when there is a significant difference between temperatures that provide desired vapour pressures, it is preferable to perform deposition from separate sources of deposition.

The mixing ratio (weight ratio) of the first host and the second host may be such that the proportion of the first host relative to the sum of the first host and the second host is 20% to 60%, preferably more than 20% and less than 55% and more preferably 30% to 50%.

The structure of the organic EL element of the present invention is now described by referring to the drawing. However, the structure of the organic EL element of the present invention is not limited thereto.

Fig. 1 is a section view illustrating a structural example of a general organic EL element used in the present invention. 1 represents a substrate, 2 represents an anode, 3 represents a hole injection layer, 4 represents a hole transport layer, 5 represents a light emitting layer, 6 represents an electron transport layer and 7 represents a cathode. The organic EL element of the present invention may have an exciton blocking layer adjacent to the light emitting layer and may have an electron blocking layer between the light emitting layer and the hole injection layer. The exciton blocking layer may be inserted on the side of either the anode or cathode of the light emitting layer or may be inserted on both sides. The organic EL element of the present invention has the anode, the light emitting layer and the cathode as requisite layers, and preferably has, other than the requisite layers, a hole injection transport layer and an electron injection transport layer and preferably further has a hole blocking layer between the light emitting layer and the electron injection transport layer. The hole injection transport layer means either or both a hole injection layer and a hole transport layer and the electron injection transport layer means either or both an electron injection layer and an electron transport layer.

It is also possible to have a structure that is reverse of the structure illustrated in Fig. 1, namely it is possible to stack, on a substrate 1, a cathode 7, an electron transport layer 6, a light emitting layer 5, a hole transport layer 4 and an anode 2 in this order. In this case, again, it is also possible to add or omit a layer, if necessary.

### - Substrate -

The organic EL element of the present invention is preferably supported by a substrate. The substrate is not particularly limited and may be one that is conventionally used for organic EL elements. Examples thereof include those formed from glass, transparent plastics, quartz and the like.

### - Anode -

A material of the anode in the organic EL element is preferably a material formed from a metal, alloy or electric conductive compound having high work function (4 eV or more) or a mixture of the foregoing. Specific examples of the electrode material include metals such as Au and conductive transparent materials such as CuI, indium tin oxide (ITO), SnO₂ and ZnO. Alternatively, an amorphous material that may form a transparent conductive film such as IDIXO (In₂O₃-ZnO) may be used. The anode may be formed from the electrode material by the process such as deposition or sputtering that forms a thin film on which a pattern having a desired shape may be formed by photolithography. Alternatively, when a strict pattern accuracy is not required (around 100 µm or more), a pattern may be formed during deposition or sputtering of the electrode material through a mask having a desired shape. Alternatively, when an applicable substance such as an organic conductive compound is used, wet film formation process such as printing or coating may be used. When light emitted from the anode is extracted, it is desirable that the anode has a transmittance of higher than 10% and the anode has a sheet resistance of several hundred Ω/square or less. The film thickness may vary according to the material and may be generally selected within the range of 10 to 1000 nm and preferably 10 to 200 nm.

### - Cathode -

Meanwhile, a material of the cathode may be a material formed from a metal (referred to as an electron injecting metal), alloy or electric conductive compound having low work function (4 eV or less) or a mixture of the foregoing. Specific examples of the electrode material include sodium, sodium-potassium alloys, magnesium, lithium, magnesium/copper mixtures, magnesium/silver mixtures, magnesium/aluminium mixtures, magnesium/indiummixtures, aluminium/aluminium oxide (Al₂O₃) mixtures, indium, lithium/aluminium mixtures, rare-earth metals and the like. Among others, in terms of electron injection ability and durability against oxidation and the like, a mixture of an electron injecting metal and a second metal that is stable and has a higher work function than the electron injecting metal such as a magnesium/silver mixture, a magnesium/aluminium mixture, a magnesium/indium mixture, an aluminium/aluminium oxide (Al₂O₃) mixture and a lithium/aluminium mixture, aluminium and the like are suitable. The cathode may be formed from the material of the cathode by the process such as deposition or sputtering that form a thin film. The cathode preferably has a sheet resistance of several hundred Ω/square or less, and a film thickness selected within the range of generally 10 nm to 5 µm and preferably 50 to 200 nm. In order to transmit emitted light, it is advantageous that one of the anode and cathode in the organic EL element is transparent or semi-transparent because of improved luminance.

A transparent or semi-transparent cathode may be prepared by forming a film of the above metal with a thickness of 1 to 20 nm on the cathode and then forming thereon the conductive transparent material exemplified for the anode. By modifying this procedure, an element having an anode and a cathode both of which have permeability may be prepared.

### - Light emitting layer -

The light emitting layer is a layer where a hole and an electron injected from the anode and the cathode, respectively, recombine to generate an exciton and light is then emitted. The light emitting layer contains an organic luminescence dopant material and a host material.

As the host material in the light emitting layer, the first host represented by general formula (1) and the second host represented by general formula (2) are used. One or more well-known host materials may further be used in combination, and the amount thereof may be 50 wt% or less and preferably 25 wt% or less relative to the sum of the host materials.

The first host and the second host may be deposited from respective sources of deposition or may be preliminarily mixed before deposition to obtain a preliminary mixture and simultaneously deposited from one source of deposition. Preliminarily mixing may be carried out by a well-known method such as grinding/mixing and it is preferable that mixing is performed as uniformly as possible.

When the luminescence dopant material used is a phosphorescent dopant, it is preferable that the phosphorescent dopant contains an organic metal complex containing at least one metal selected from ruthenium, rhodium, palladium, silver, rhenium, osmium, iridium, platinum and gold. Specifically, iridium complexes disclosed in J. Am. Chem. Soc. 2001, 123, 4304 and Japanese Translation of PCT Application No. 2013-53051 are suitable. However, the phosphorescent dopant is not limited thereto.

The light emitting layer may contain only one or two or more phosphorescence dopant materials. The content of the phosphorescence dopant material relative to the host material is preferably 0.1 to 30 wt% and more preferably 1 to 20 wt%.

Specific examples of the phosphorescence dopant material include those indicated below without particular limitation.

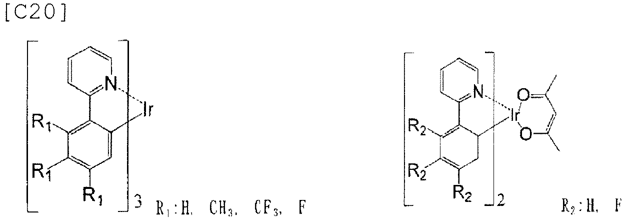

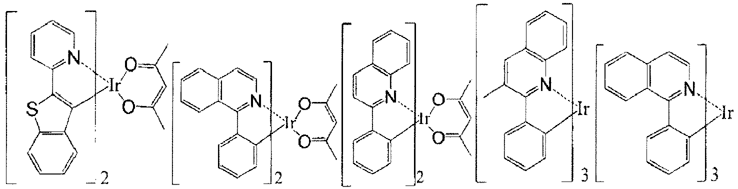

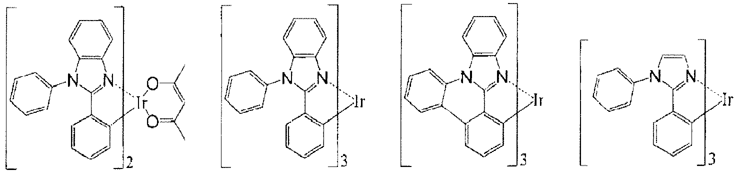

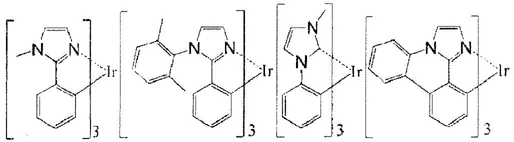

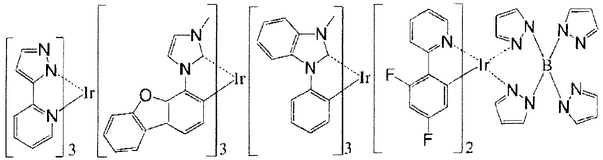

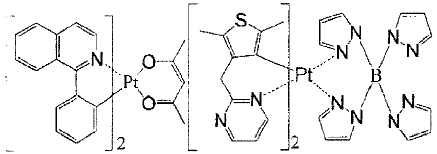

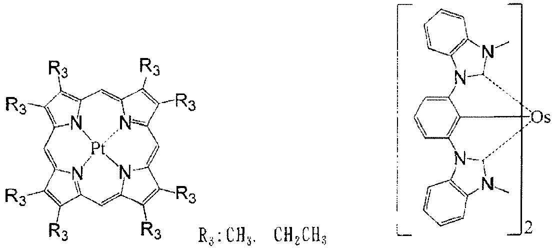

When the luminescence dopant material used is a fluorescence dopant, examples of the fluorescence dopant include, but are not limited to, metal complexes typically including metal complexes of benzoxazole derivatives, benzothiazole derivatives, benzimidazole derivatives, styryl benzene derivatives, polyphenyl derivatives, diphenyl butadiene derivatives, tetraphenyl butadiene derivatives, naphthalimide derivatives, coumarin derivatives, condensed aromatic compounds, perinone derivatives, oxadiazole derivatives, oxazine derivatives, aldazine derivatives, pyralidine derivatives, cyclopentadiene derivatives, bisstyrylanthracene derivatives, quinacridon derivatives, pyrrolopyridine derivatives, thiadiazolopyridine derivatives, styrylamine derivatives, diketopyrrolopyrrole derivatives, aromatic dimethylidyne compounds and 8-quinolinol derivatives, metal complexes of pyrromethene derivatives, rare-earth complexes and transition metal complexes; polymer compounds such as polythiophene, polyphenylene and polyphenylene vinylene; organic silane derivatives; and the like. Preferably, condensed aromatic derivatives, styryl derivatives, diketopyrrolopyrrole derivatives, oxazine derivatives, pyrromethene metal complexes, transition metal complexes and lanthanoid complexes may be mentioned and more preferably, naphthalene, pyrene, chrysene, triphenylene, benzo[c]phenanthrene, benzo[a]anthracene, pentacene, perylene, fluoranthene, acenaphthofluoranthene, dibenzo[a,j]anthracene, dibenzo[a,h]anthracene, benzo[a]naphthalene, hexacene, naphtho[2,1-f]isoquinoline, α-naphthaphenanthridine, phenanthroxazole, quinolino[6,5-f]quinoline, benzothiophanthrene and the like may be mentioned. The above compounds may contain a substituent which may be an alkyl group, an aryl group, an aromatic heterocyclic group or a diarylamino group.

The light emitting layer may contain only one or two or more fluorescence dopant materials. The content of the fluorescence dopant material relative to the host material is preferably 0.1% to 20% and more preferably 1% to 10%.

When the luminescence dopant material used is a thermally activated delayed fluorescence dopant, examples of the thermally activated delayed fluorescence dopant include, but are not limited to, metal complexes such as tin complexes and copper complexes, an indolocarbazole derivative disclosed in WO 2011/070963, a cyanobenzene derivative disclosed in Nature 2012, 492, 234, carbazole derivatives and the like.

Specific examples of the thermally activated delayed fluorescence dopant material include those indicated below without particular limitation.

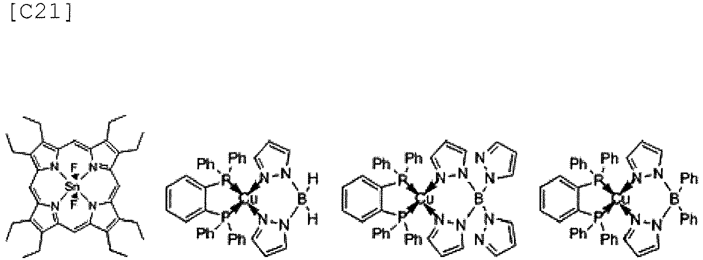

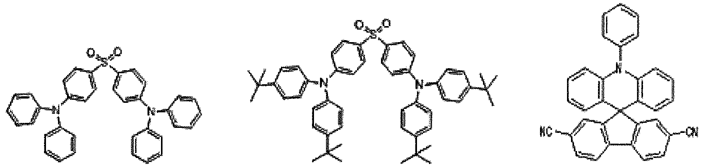

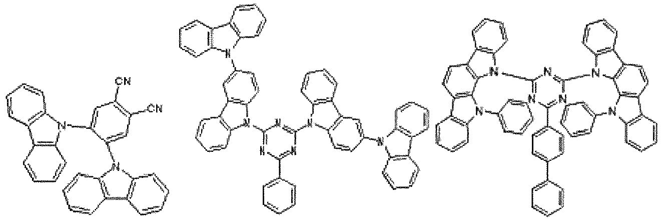

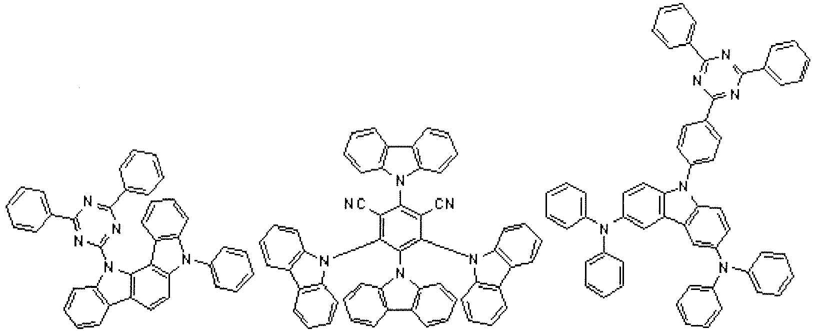

The light emitting layer may contain only one or two or more thermally activated delayed fluorescence dopant materials. The thermally activated delayed fluorescence dopant may be used by mixing the same with the phosphorescent dopant or the fluorescence dopant. The content of the thermally activated delayed fluorescence dopant material relative to the host material is preferably 0.1% to 50% and more preferably 1% to 30%.

### - Injection layer -

An injection layer refers to a layer provided between an electrode and an organic layer for reducing driving voltage and improving emission luminance, includes a hole injection layer and an electron injection layer and may be provided between an anode and a light emitting layer or a hole transport layer and between a cathode and a light emitting layer or an electron transport layer. The injection layer may be optionally provided.

### - Hole blocking layer -

The hole blocking layer has, in a broad sense, the function of an electron transport layer and is formed from a hole blocking material that has a capability of electron transport and has significantly low capability of hole transport and may increase the probability of recombination of electrons and holes in the light emitting layer by transporting electrons while blocking holes.

The hole blocking layer may include well-known hole blocking layer materials.

### - Electron blocking layer -

The electron blocking layer has, in a broad sense, the function of a hole transport layer and may transport holes while blocking electrons, thereby increasing the probability of recombination of electrons and holes in the light emitting layer.

Well-known materials of electron blocking layers may be used for the electron blocking layer. Materials of the hole transport layer described hereinbelow may also be used, if necessary. The electron blocking layer has a thickness of preferably 3 to 100 nm and more preferably 5 to 30 nm.

### - Exciton blocking layer -

The exciton blocking layer is a layer for blocking diffusion of excitons generated by recombination of holes and electrons in the light emitting layer into the charge transport layer. By inserting the exciton blocking layer, excitons may be efficiently confined in the light emitting layer and the element may have increased luminescent efficiency. In an element having two or more light emitting layers adjacent to each other, the exciton blocking layer may be inserted between two adjacent light emitting layers.

Well-known materials of exciton blocking layers may be used for the exciton blocking layer. Examples thereof include 1,3-dicarbazolylbenzene (mCP) and bis(2-methyl-8-quinolinolato)-4-phenylphenolatoaluminium (III) (BAlq) .

### - Hole transport layer -

The hole transport layer may be formed from a hole transport material that has function of hole transport. The hole transport layer may be provided singly or in plurality.

The hole transport material may have either ability of hole injection or transport or electron barrier and may be organic or inorganic. Any compound selected from conventionally known compounds may be used for the hole transport layer. Examples of the hole transport material include porphyrin derivatives, arylamine derivatives, triazole derivatives, oxadiazole derivatives, imidazole derivatives, polyarylalkane derivatives, pyrazoline derivatives and pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline copolymers, conductive polymer oligomers particularly thiophene oligomers and the like. Preferably, porphyrin derivatives, arylamine derivatives and styrylamine derivatives are used and more preferably, arylamine compounds are used.

### - Electron transport layer -

The electron transport layer is formed from a material that has the function of electron transport. The electron transport layer may be provided singly or in plurality.

It is sufficient that the electron transport material (which sometimes also serves as a hole blocking material) has the function of transmitting electrons injected from cathode to light emitting layer. Any compound selected from conventionally known compounds may be used for the electron transport layer. Examples thereof include polycyclic aromatic derivatives such as naphthalene, anthracene and phenanthroline, tris(8-quinolilato)aluminium (III) derivatives, phosphine oxide derivatives, nitro-substituted fluorene derivatives, diphenylquinone derivatives, thiopyran dioxide derivatives, carbodiimide, fluorenylidenmethane derivatives, anthraquinodimethane and anthrone derivatives, bipyridine derivatives, quinoline derivatives, oxadiazole derivatives, benzimidazole derivatives, benzothiazole derivatives, indolocarbazole derivatives and the like. Polymer materials having the foregoing materials introduced in polymer chains or having the foregoing materials as backbones of the polymers may also be used.

### Examples

The present invention is hereinafter more specifically described by way of Examples. However, the present invention is not limited to the Examples and may be carried out in various forms without departing from the scope of the present invention.

### Example 1

Thin films were stacked by vacuum deposition with a degree of vacuum of 4.0 × 10⁻⁵ Pa on a glass substrate on which an anode formed from ITO having a thickness of 110 nm was formed. On ITO, a hole injection layer, HAT-CN, was formed with a thickness of 25 nm and then a hole transport layer, NPD, was formed with a thickness of 45 nm. An electron blocking layer, HT-1, was then formed with a thickness of 10 nm. A first host, compound 1-16, a second host, compound 2-18, and a luminescence dopant, Ir(piq)₂acac, were co-deposited from different sources of deposition, thereby forming a light emitting layer with a thickness of 40 nm. The co-deposition was carried out under deposition conditions in which the concentration of Ir(piq)₂acac was 6.0 wt% and the weight ratio between the first host and the second host was 30:70. Then, an electron transport layer, ET-1, was formed with a thickness of 37.5 nm. On the electron transport layer, an electron injection layer, LiF, was formed with a thickness of 1 nm. Finally, on the electron injection layer, a cathode, Al, was formed with a thickness of 70 nm, thereby preparing an organic EL element.

### Example 2

An organic EL element was prepared under the same conditions as in Example 1 except that co-deposition was carried out under deposition conditions in which the weight ratio between the first host and the second host was 50:50.

### Examples 3 to 10

Organic EL elements were prepared under the same conditions as in Example 1 except that the first host used was any of compounds 1-16, 1-7 and 1-27 and the second host used was any of compounds 2-18, 2-3, 2-88 and 2-97.

### Example 11

Compound 1-16 (0.30 g) and compound 2-18 (0.70 g) were weighed and mixed while grinding in a mortar, thereby preparing preliminary mixture H1.

Thin films were stacked by vacuum deposition with a degree of vacuum of 4.0 × 10⁻⁵ Pa on a glass substrate on which an anode formed from ITO having a thickness of 110 nm was formed. On ITO, a hole injection layer, HAT-CN, was formed with a thickness of 25 nm and then a hole transport layer, NPD, was formed with a thickness of 45 nm. An electron blocking layer, HT-1, was then formed with a thickness of 10 nm. Then, a host, the preliminary mixture H1, and a luminescence dopant, Ir(piq)₂acac, were co-deposited from different sources of deposition, thereby forming a light emitting layer with a thickness of 40 nm. The co-deposition was carried out under the deposition condition in which the concentration of Ir(piq)₂acac was 6.0 wt% . Then, an electron transport layer, ET-1, was formed with a thickness of 37.5 nm. On the electron transport layer, an electron injection layer, LiF, was formed with a thickness of 1 nm. Finally, on the electron injection layer, a cathode, Al, was formed with a thickness of 70 nm, thereby preparing an organic EL element.

### Comparative Example 1

An organic EL element was prepared in the same manner as in Example 11 except that the host used was only compound 1-16.

### Comparative Example 2

An organic EL element was prepared in the same manner as in Example 11 except that the host used was only compound 2-18.

### Comparative Example 3

An organic EL element was prepared in the same manner as in Example 1 except that the first host used was RH-1 and the second host used was RH-2.

The compounds used in Examples are shown below.

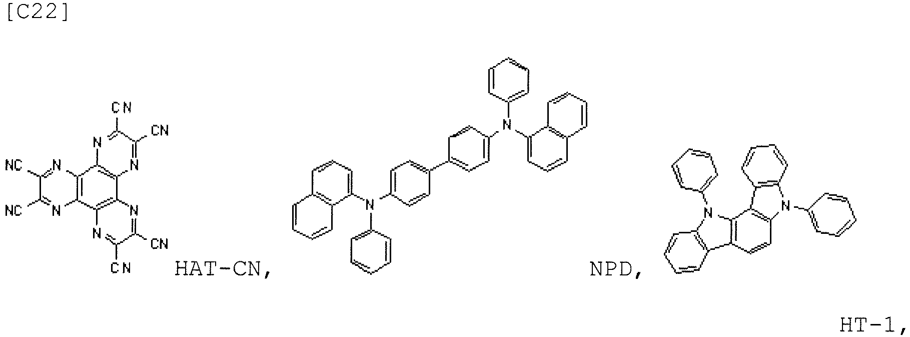

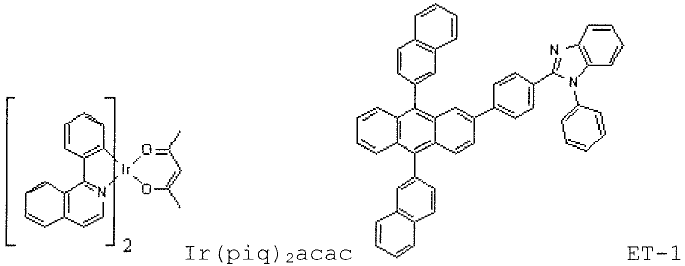

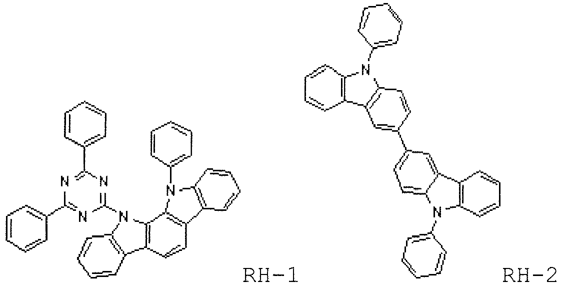

The compounds used as the first host and the second host and proportions (weight ratios) thereof are indicated in Table 1.

**[Table 1]**

| | First host | Second host |
|---|---|---|
| Example 1 | 1-16 (30%) | 2-18 (70%) |
| Example 2 | 1-16 (50%) | 2-18 (50%) |
| Example 3 | 1-16 (30%) | 2-3 (70%) |
| Example 4 | 1-16 (30%) | 2-88 (70%) |
| Example 5 | 1-16 (30%) | 2-97 (70%) |
| Example 6 | 1-7 (30%) | 2-18 (70%) |
| Example 7 | 1-7 (30%) | 2-3 (70%) |
| Example 8 | 1-7 (30%) | 2-88 (70%) |
| Example 9 | 1-27 (30%) | 2-18 (70%) |
| Example 10 | 1-27 (30%) | 2-3 (70%) |
| Example 11 | 1-16 (30%) | 2-18 (70%) |
| Comparative Example 1 | 1-16 | - |
| Comparative Example 2 | - | 2-18 |
| Comparative Example 3 | RH-1 (30%) | RH-2 (70%) |

When the organic EL elements prepared in Examples 1 to 11 and Comparative Examples 1 to 3 were connected to external power source to apply direct voltage, luminescent spectra having a maximum wavelength of 620 nm were observed, indicating that luminescence from Ir(pic)₂acac was obtained.

The luminance, driving voltage, luminescent efficiency and luminance half-life of the prepared organic EL elements are indicated in Table 2. In the table, the luminance, driving voltage and luminescent efficiency are values measured at a driving current of 20 mA/cm² and are initial characteristics. In Table 2, LT95 represents a time that is required until the luminance is attenuated to 95% of the initial luminance which was 3700 cd/m² and is a lifetime characteristic.

**[Table 2]**

| | Luminance (cd/m²) | Voltage (V) | Luminescent efficiency (lm/W) | LT95 (h) |
|---|---|---|---|---|
| Example 1 | 3950 | 3.8 | 16.3 | 396 |
| Example 2 | 3870 | 3.5 | 17.3 | 278 |
| Example 3 | 3970 | 3.7 | 16.8 | 312 |
| Example 4 | 3880 | 3.9 | 15.6 | 307 |
| Example 5 | 3810 | 3.9 | 15.3 | 322 |
| Example 6 | 3790 | 3.7 | 16.0 | 297 |
| Example 7 | 3820 | 3.7 | 16.2 | 280 |
| Example 8 | 3990 | 4.0 | 15.7 | 291 |
| Example 9 | 3830 | 3.7 | 16.3 | 338 |
| Example 10 | 3770 | 3.6 | 16.4 | 325 |
| Example 11 | 3930 | 3.8 | 18.7 | 388 |
| Comparative Example 1 | 2190 | 3.3 | 10.4 | 150 |
| Comparative Example 2 | 860 | 6.8 | 2.0 | 10 |
| Comparative Example 3 | 3760 | 4.3 | 13.7 | 130 |

From Table 2, it is found that when a mixture of the first host represented by general formula (1) and the second host represented by general formula (2) was used, the lifetime characteristic was significantly extended compared to the case in which the first host and the second host were respectively used alone. In addition, it is found that even when a mixture of the first host and the second host was used, a preferable lifetime characteristic was not obtained if one of the hosts is not the compound of general formula (1).

### [Reference Signs List]

- 1: Substrate
- 2: Anode
- 3: Hole injection layer
- 4: Hole transport layer
- 5: Light emitting layer
- 6: Electron transport layer
- 7: Cathode

## Claims

1. An organic electroluminescence element comprising one or more light emitting layers between an anode and a cathode opposing each other, wherein at least one light emitting layer contains a first host selected from compounds represented by the following general formula (1), a second host selected from compounds represented by the following general formula (2) and a luminescence dopant material: 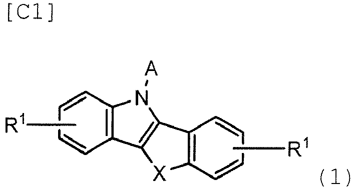 wherein X represents N-A, oxygen or sulphur; A is respectively and independently represent an aromatic hydrocarbon group having 6 to 30 carbon atoms or an aromatic heterocyclic group having 3 to 30 carbon atoms; R¹ is respectively and independently represent hydrogen, an alkyl group having 1 to 10 carbon atoms, an aromatic hydrocarbon group having 6 to 10 carbon atoms or an aromatic heterocyclic group having 3 to 12 carbon atoms; 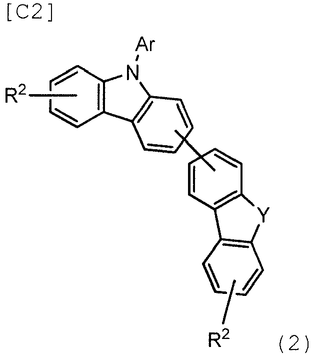 wherein Y represents N-Ar, oxygen or sulphur; Ar represents an aromatic hydrocarbon group having 6 to 30 carbon atoms or an aromatic heterocyclic group having 3 to 30 carbon atoms; R² is respectively and independently represent hydrogen, an alkyl group having 1 to 10 carbon atoms, an aromatic hydrocarbon group having 6 to 10 carbon atoms or an aromatic heterocyclic group having 3 to 12 carbon atoms, provided that when Y represents N-Ar, X in general formula (1) does not represent N-A.

2. The organic electroluminescence element according to claim 1, wherein general formula (2) is represented by the following general formula (3): 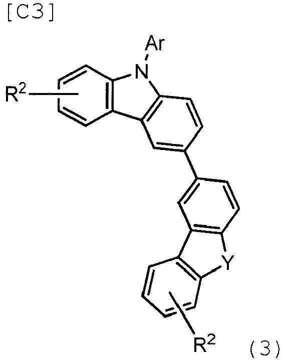 wherein Y, Ar and R² have the same meanings as in general formula (2) .

3. The organic electroluminescence element according to claim 1, wherein general formula (1) is represented by the following general formula (4): 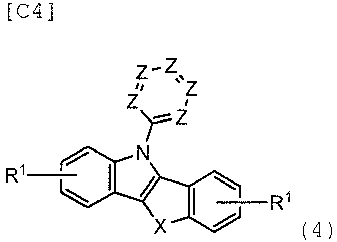 wherein Z's respectively and independently represent N or CR³ and at least one Z is N; and R³ is respectively and independently represent hydrogen, an aromatic hydrocarbon group having 6 to 12 carbon atoms or an aromatic heterocyclic group having 3 to 12 carbon atoms.

4. The organic electroluminescence element according to claim 1, wherein X in general formula (1) is oxygen or sulphur.

5. The organic electroluminescence element according to claim 1, wherein Y in general formula (2) is N-Ar.

6. The organic electroluminescence element according to any one of claims 1 to 5, wherein the light emitting layer has a layer obtained by deposition of a host material containing a preliminary mixture of the first host and the second host.

7. The organic electroluminescence element according to any one of claims 1 to 5, wherein a proportion of the first host relative to the sum of the first host and the second host is more than 20 wt% and less than 55 wt%.

8. The organic electroluminescence element according to claim 6, wherein a proportion of the first host relative to the sum of the first host and the second host is more than 20 wt% and less than 55 wt%.

9. The organic electroluminescence element according to any one of claims 1 to 5, wherein the luminescence dopant material is an organic metal complex containing at least one metal selected from the group consisting of ruthenium, rhodium, palladium, silver, rhenium, osmium, iridium, platinum and gold.

10. The organic electroluminescence element according to claim 7, wherein the luminescence dopant material is an organic metal complex containing at least one metal selected from the group consisting of ruthenium, rhodium, palladium, silver, rhenium, osmium, iridium, platinum and gold.

## Patentansprüche

1. Ein organisches Elektrolumineszenzelement, umfassend eine oder mehrere lichtemittierende Schichten zwischen einer Anode und einer Kathode, die einander gegenüberliegen, wobei mindestens eine lichtemittierende Schicht einen ersten Wirt, ausgewählt aus Verbindungen, die durch die nachstehende allgemeine Formel (1) dargestellt sind, einen zweiten Wirt, ausgewählt aus Verbindungen, die durch die nachstehende allgemeine Formel (2) dargestellt sind, und ein Lumineszenz-Dotiermaterial enthält: 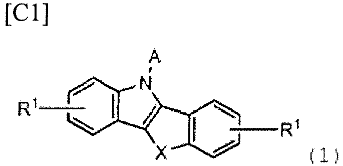 wobei X N-A, Sauerstoff oder Schwefel darstellt; A jeweils und unabhängig voneinander eine aromatische Kohlenwasserstoffgruppe mit 6 bis 30 Kohlenstoffatomen oder eine aromatische heterocyclische Gruppe mit 3 bis 30 Kohlenstoffatomen darstellt; R¹ jeweils und unabhängig voneinander Wasserstoff, eine Alkylgruppe mit 1 bis 10 Kohlenstoffatomen, eine aromatische Kohlenwasserstoffgruppe mit 6 bis 10 Kohlenstoffatomen oder eine aromatische heterocyclische Gruppe mit 3 bis 12 Kohlenstoffatomen darstellt: 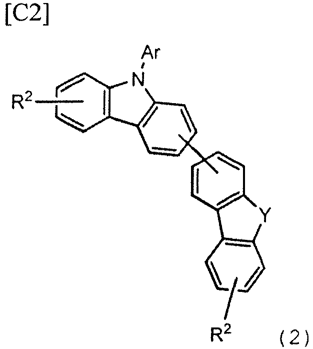 wobei Y N-Ar, Sauerstoff oder Schwefel darstellt; Ar eine aromatische Kohlenwasserstoffgruppe mit 6 bis 30 Kohlenstoffatomen oder eine aromatische heterocyclische Gruppe mit 3 bis 30 Kohlenstoffatomen darstellt; R² jeweils und unabhängig voneinander Wasserstoff, eine Alkylgruppe mit 1 bis 10 Kohlenstoffatomen, eine aromatische Kohlenwasserstoffgruppe mit 6 bis 10 Kohlenstoffatomen oder eine aromatische heterocyclische Gruppe mit 3 bis 12 Kohlenstoffatomen darstellt, mit der Maßgabe, dass, wenn Y N-Ar darstellt, X in der allgemeinen Formel (1) nicht N-A darstellt.

2. Das organische Elektrolumineszenzelement nach Anspruch 1, wobei die allgemeine Formel (2) durch die nachstehende allgemeine Formel (3) dargestellt ist: 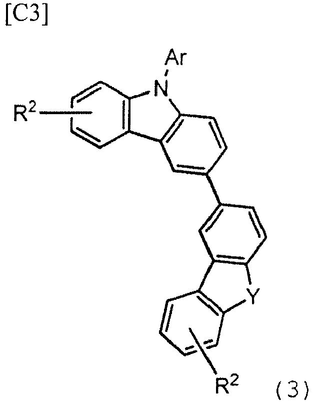 wobei Y, Ar und R² die gleichen Bedeutungen wie in der allgemeinen Formel (2) haben.

3. Das organische Elektrolumineszenzelement nach Anspruch 1, wobei die allgemeine Formel (1) durch die nachstehende allgemeine Formel (4) dargestellt ist: 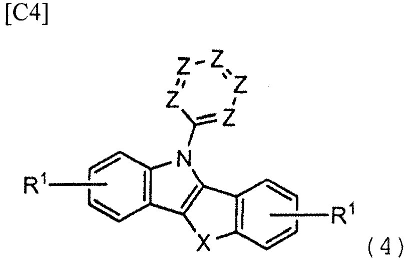 wobei die Z's jeweils und unabhängig voneinander N oder CR³ darstellen und mindestens ein Z gleich N ist; und R³ jeweils und unabhängig voneinander Wasserstoff, eine aromatische Kohlenwasserstoffgruppe mit 6 bis 12 Kohlenstoffatomen oder eine aromatische heterocyclische Gruppe mit 3 bis 12 Kohlenstoffatomen darstellt.

4. Das organische Elektrolumineszenzelement nach Anspruch 1, wobei X in der allgemeinen Formel (1) Sauerstoff oder Schwefel ist.

5. Das organische Elektrolumineszenzelement nach Anspruch 1, wobei Y in der allgemeinen Formel (2) N-Ar ist.

6. Das organische Elektrolumineszenzelement nach einem der Ansprüche 1 bis 5, wobei die lichtemittierende Schicht eine Schicht aufweist, die durch Abscheidung eines Wirtsmaterials erhalten wird, das ein vorläufiges Gemisch aus dem ersten Wirt und dem zweiten Wirt enthält.

7. Das organische Elektrolumineszenzelement nach eine der Ansprüche 1 bis 5, wobei ein Anteil des ersten Wirts, bezogen auf die Summe des ersten Wirts und des zweiten Wirts, mehr als 20 Gew.-% und weniger als 55 Gew.-% beträgt.

8. Das organische Elektrolumineszenzelement nach Anspruch 6, wobei ein Anteil des ersten Wirts, bezogen auf die Summe des ersten Wirts und des zweiten Wirts, mehr als 20 Gew.-% und weniger als 55 Gew.-% beträgt.

9. Das organische Elektrolumineszenzelement nach einem der Ansprüche 1 bis 5, wobei das Lumineszenz-Dotiermaterial ein organischer Metallkomplex ist, der mindestens ein Metall enthält, das ausgewählt ist aus der Gruppe bestehend aus Ruthenium, Rhodium, Palladium, Silber, Rhenium, Osmium, Iridium, Platin und Gold.

10. Das organische Elektrolumineszenzelement nach Anspruch 7, wobei das Lumineszenz-Dotiermaterial ein organischer Metallkomplex ist, der mindestens ein Metall enthält, das ausgewählt ist aus der Gruppe bestehend aus Ruthenium, Rhodium, Palladium, Silber, Rhenium, Osmium, Iridium, Platin und Gold.

## Revendications

1. Elément électroluminescent organique comprenant une ou plusieurs couches émettrices de lumière entre une anode et une cathode s'opposant l'une à l'autre, dans lequel au moins une couche émettrice de lumière contient un premier hôte choisi parmi les composés représentés par la formule générale (1) qui suit, un deuxième hôte choisi parmi les composés représentés par la formule générale (2) qui suit, et un matériau dopant de luminescence : 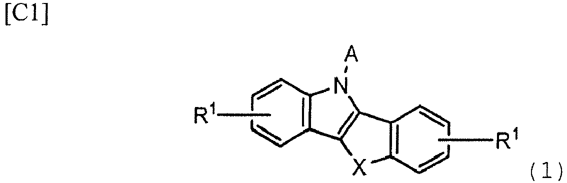 dans laquelle X représente N-A, l'oxygène ou le soufre ; A représente respectivement et indépendamment un groupe hydrocarboné aromatique ayant 6 à 30 atomes de carbone ou un groupe hétérocyclique aromatique ayant 3 à 30 atomes de carbone ; R¹ représente respectivement et indépendamment l'hydrogène, un groupe alkyle ayant 1 à 10 atomes de carbone, un groupe hydrocarboné aromatique ayant 6 à 10 atomes de carbone ou un groupe hétérocyclique aromatique ayant 3 à 12 atomes de carbone ; 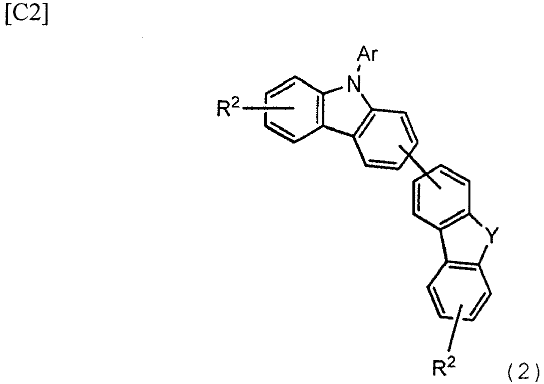 dans laquelle Y représente N-Ar, l'oxygène ou le soufre ; Ar représente un groupe hydrocarboné aromatique ayant 6 à 30 atomes de carbone ou un groupe hétérocyclique aromatique ayant 3 à 30 atomes de carbone ; R² représente respectivement et indépendamment l'hydrogène, un groupe alkyle ayant 1 à 10 atomes de carbone, un groupe hydrocarboné aromatique ayant 6 à 10 atomes de carbone ou un groupe hétérocyclique aromatique ayant 3 à 12 atomes de carbone, sous réserve que, lorsque Y représente N-Ar, X dans la formule générale (1) ne représente pas N-A.

2. Elément électroluminescent organique selon la revendication 1, dans lequel la formule générale (2) est représentée par la formule générale (3) suivante : 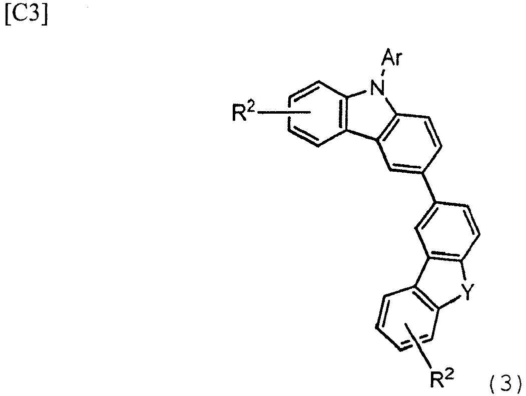 dans laquelle Y, Ar et R² ont les mêmes significations que dans la formule générale (2).

3. Elément électroluminescent organique selon la revendication 1, dans lequel la formule générale (1) est représentée par la formule générale (4) suivante : 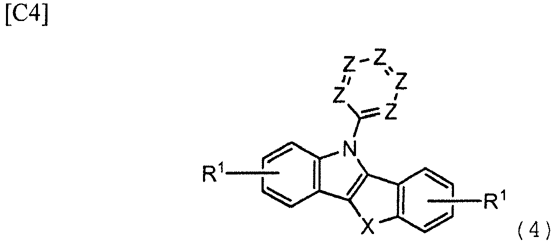 dans laquelle les Z représentent respectivement et indépendamment N ou CR³ et au moins un Z est N ; et R³ représente respectivement et indépendamment l'hydrogène, un groupe hydrocarboné aromatique ayant 6 à 12 atomes de carbone ou un groupe hétérocyclique aromatique ayant 3 à 12 atomes de carbone.

4. Elément électroluminescent organique selon la revendication 1, dans lequel X dans la formule générale (1) est l'oxygène ou le soufre.

5. Elément électroluminescent organique selon la revendication 1, dans lequel Y dans la formule générale (2) est N-Ar.

6. Elément électroluminescent organique selon l'une quelconque des revendications 1 à 5, dans lequel la couche émettrice de lumière a une couche obtenue par dépôt d'un matériau hôte contenant un mélange préliminaire du premier hôte et du deuxième hôte.

7. Elément électroluminescent organique selon l'une quelconque des revendications 1 à 5, dans lequel la proportion du premier hôte par rapport à la somme du premier hôte et du deuxième hôte est supérieure à 20 % en poids et inférieure à 55 % en poids.

8. Elément électroluminescent organique selon la revendication 6, dans lequel la proportion du premier hôte par rapport à la somme du premier hôte et du deuxième hôte est supérieure à 20 % en poids et inférieure à 55 % en poids.

9. Elément électroluminescent organique selon l'une quelconque des revendications 1 à 5, dans lequel le matériau dopant de luminescence est un complexe organométallique contenant au moins un métal choisi dans le groupe constitué par le ruthénium, le rhodium, le palladium, l'argent, le rhénium, l'osmium, l'iridium, le platine et l'or.

10. Elément électroluminescent organique selon la revendication 7, dans lequel le matériau dopant de luminescence est un complexe organométallique contenant au moins un métal choisi dans le groupe constitué par le ruthénium, le rhodium, le palladium, l'argent, le rhénium, l'osmium, l'iridium, le platine et l'or.
